**Europäisches Patentamt**

**European Patent Office**

**Office européen des brevets**

(19)

(11) Publication number : **0 353 671 B1**

# EUROPEAN PATENT SPECIFICATION

(12)

(45) Date of publication of patent specification :
**30.09.92 Bulletin 92/40**

(51) Int. Cl.⁵ : **F25B 21/02, H01L 35/30, H01L 23/38**

(21) Application number : **89114035.2**

(22) Date of filing : **29.07.89**

(54) **Cooling apparatus.**

(30) Priority : **01.08.88 JP 192536/88**

(43) Date of publication of application :
**07.02.90 Bulletin 90/06**

(45) Publication of the grant of the patent :
**30.09.92 Bulletin 92/40**

(84) Designated Contracting States :
**DE FR GB**

(56) References cited :
**EP-A- 0 271 704**
**DE-A- 3 005 112**
**FR-A- 700 013**
**FR-A- 1 205 465**
**FR-A- 2 274 142**
**GB-A- 832 422**
**US-A- 2 994 203**
**US-A- 3 097 027**
**US-A- 3 127 749**
**US-A- 3 276 914**
**US-A- 3 648 470**
**US-A- 3 823 567**

(73) Proprietor : **MATSUSHITA ELECTRIC INDUSTRIAL CO., LTD.**
**1006, Oaza Kadoma**
**Kadoma-shi, Osaka-fu, 571 (JP)**
Proprietor : **Ishimaru, Hajime**
**2079, Uenomuro**
**Tsukuba-shi Ibaraki-ken (JP)**

(72) Inventor : **Saeki, Hiroshi**
**1-16-27, Hanabatake**
**Tsukuba-shi Ibaraki-ken (JP)**
Inventor : **Ikeda, Junji**
**29, Koyodai**
**Ikoma-shi Nara-ken (JP)**
Inventor : **Ishimaru, Hajime**
**2079, Uenomuro**
**Tsukuba-shi Ibaraki-ken (JP)**

(74) Representative : **Eisenführ, Speiser & Partner**
**Martinistrasse 24**
**W-2800 Bremen 1 (DE)**

EP 0 353 671 B1

## Description

### BACKGROUND OF THE INVENTION

The present invention relates to a cooling apparatus according to the preamble of claim 1. Specifically, the invention relates to an apparatus for cooling various types of heating sources in vacuum such as cooling a wafer in a manufacturing process within a vacuum apparatus, cooling a motor for vacuum use, cooling the other heating sources, cooling a shroud for floating molecule trap use, cooling a calculation circuit enclosed in vacuum, and so on.

Conventionally, in, for example, a vacuum apparatus, a water-cooled pipe, a heat pipe or the like is normally used to cool a wafer located in the manufacturing process or a motor for vacuum use. Also, the calculation circuits of the conventional large-size computers are cooled with the use of liquid nitrogen without the enclosing thereof in the vacuum.

FR-A-1 205 465 discloses a thermoelectric cooling device comprising a first elongated element consisting of a bulk positive thermoelectric material and a second elongated element consisting of a bulk negative thermoelectric material, both extending through a chamber wall. Inside the chamber the ends of said first and second elements are soldered together by means of a third metallic element. Outside the chamber said first and second elements are connected through the electrodes of a DC power supply. In order to achieve sufficient mechanic stability of the elongated elements only certain kinds of thermoelectric materials can be used.

It is the object of the present invention to provide for a thermoelectric cooling device which can take advantage of any thermoelectric material and thereby improving the performance of the device.

In accomplishing this object the cooling apparatus of the present invention comprises a cooling apparatus comprising:
a first element formed of a first thermoelectric material, extending through a chamber wall, enclosing a chamber, from a position within that chamber to a position outside of said chamber;
a second element formed of a second thermoelectric material different than said first thermoelectric material, and extending through said chamber wall from a position within said chamber to a position outside of said chamber;
a first electrode;
a first splicing portion between said first and second thermoelectric materials and said first electrode becoming a cooling portion;
second electrodes;
second splicing portions between said first and second thermoelectric materials and said second electrodes, respectively, becoming a heating portion;
the cooling portion and the heating portion being disposed on opposite sides of the chamber wall;
and a DC power supply means electrically inserted between the second electrodes so as to form an electric circuit, characterized in that the apparatus further comprises a basic plate, said first and second elements being formed as thin membranes of thermoelectric materials on said basic plate extending through the chamber wall.

According to the prefered embodiment of the present invention the basic plate is made of a deformable material, so that the cooling device can be used at locations which are hardly accessible.

Preferably the thermoelectric material is formed linear, also the linear thermoelectric material is covered with a metallic sheath.

Also, a cooling means is provided on the heating portion.

The present invention has a following function in the above-described construction.

Current is fed by the DC power supply into the circuit formed by the use of the thermoelectric material, so that the heating source may be electronically cooled with the cooling portion through the Peltier effect disposed in the vacuum.

The cooling portion may be easily connected with the heating source by the use of the flexibility of the basic plate.

Also, although the cooling efficiency of the heating source by the cooling portion is improved as no convection currents exist in the vacuum, the transferring of the heat of the heating portion to the cooling portion by the thermoelectric material may be controlled so as to improve the cooling efficiency all the more.

### BRIEF DESCRIPTION OF THE DRAWINGS

These and other objects and features of the present invention will become apparent from the following description taken in conjunction with the preferred embodiment thereof with reference to the accompanying drawings, in which;

Fig. 1 is a sectional view of the essential portions for illustrating the principle of a cooling apparatus in a first embodiment;

Fig. 2 (a) through (c) show a cooling apparatus in a second embodiment, with the (a) thereof being a sectional view of the essential portions, the (b) thereof being an arrow view taken along a line IIb - IIb of the (a) thereof, the (c) thereof being a left side view of the (a) thereof.

Fig. 3 (a), (b) show a cooling apparatus in of the present invention, with the (a) thereof being a sectional view of the essential portions, the (b) thereof being a IIIb arrow sectional view of the (a) thereof.

Before the description of the present invention proceeds, it is to be noted that like parts are designated by like reference numerals through the accompanying drawings.

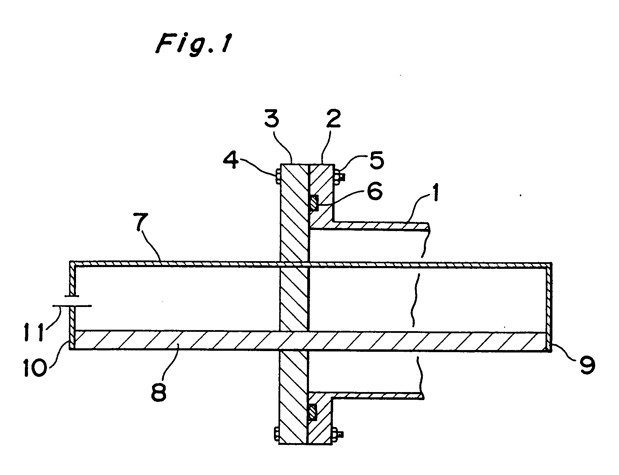

Referring now to the drawings, there is shown in Fig. 1, a sectional view of the essential portions for illustrating the principle of a cooling apparatus in a first embodiment. The vacuum bulkhead 3 is mounted with bolts 4, nuts 5 on the flange 2 of a chamber 1 which becomes vacuum, an 0 ring 6 being interposed in a compressed condition between the flange 2 and the vacuum bulkhead 3, with the gap between them being sealed. The first, second thermoelectric materials 7, 8 are made of foreign kinds of materials such as Sb, Bi, with the end portions of the first, second thermoelectric materials 7 and 8 are connected between them to form a circuit. The first, second thermoelectric materials 7 and 8 are extended through the vacuum bulkhead 3 and are secured with an epoxide series bonding agent, and also are retained in an airtight condition. The cooling portion 9 and the heating portion 10 by a Peltier effect are respectively disposed within the chamber 1 and in the air. The DC power supply 11 is inserted halfway thereof in the air into the first thermoelectric material 7. And the cooling portion 9 is connected with the heating supply (not shown).

In the above-described construction, the operation thereof will be described hereinafter.

The current is fed into a circuit using the first, second thermoelectric materials 7, 8 by a DC power supply 11, and the cooling portion 9 is cooled by the Peltier effect to heat the heating portion 10. And the heating source may be electronically cooled by the cooling operation of the cooling portion 9. At this time, there is less in convection current in the vacuum, so that the cooling efficiency of the heating source by the cooling portion 9 may be improved. Also, as the cooling operation is electronically effected as described hereinabove, the response speed of the cooling may be improved as compared with the water cooling system or the like in the conventional embodiment.

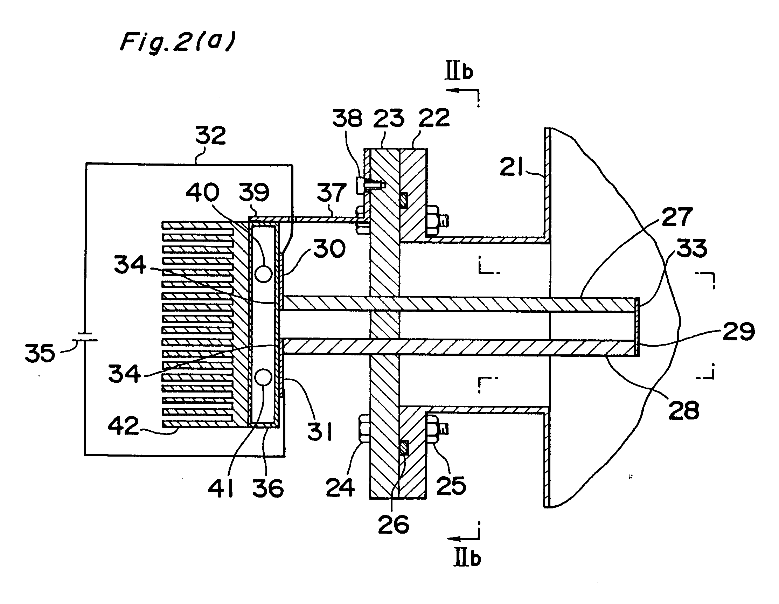

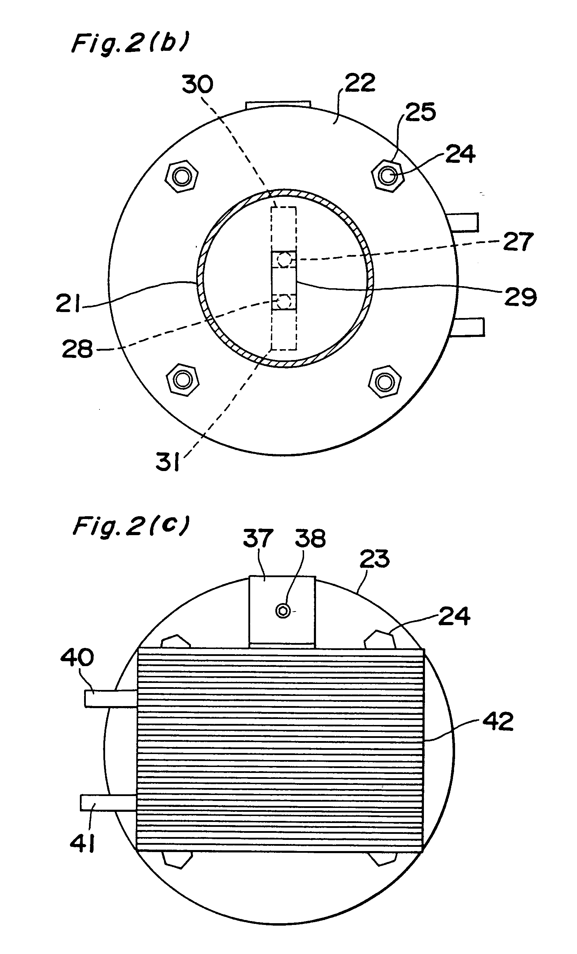

The second embodiment will be described hereinafter. Fig. 2 (a) through (c) show the cooling apparatus in the second embodiment. Fig. 2 (a) shows the sectional view of the essential portions. Fig. 2 (b) is an arrow view taken along the IIb - IIb of the (a) thereof. Fig. 2 (c) is a left side view of the (a) thereof.

As shown in Fig. 2 (a) through (c), the vacuum bulkhead 23 is mounted with bolts 24, nuts 25 on the flange 22 of the chamber 21 which becomes vacuum, and an 0 ring 26 is interposed in a compressed condition between the flange 22 and the vacuum bulkhead 23, with the gap between them being sealed. The first, second thermoelectric materials 27, 28 are formed linear of semiconductors of, for example, $Bi_2Te_3 + Sb_2Te_3$, $Bi_2Te_3 + Bi_2Se_3$. And preferably they are covered with metallic sheaths. An electronic plate 29 made of Cu is spliced by solder of an In radical between one-end portions of the first, second thermoelectric materials 27, 28, and the electrode plates 30, 31 made of Cu are spliced by solder of an In radical with the respective other ends of the first, second thermoelectric materials 27, 28, so that the Cu line 32 is taken out from the electrode plates 30, 31 to form the circuit. And the splicing portion between the first, second thermoelectric materials 27, 28 and the electrode plate 29 becomes a cooling portion 33 by the Peltier effect, and the splicing portion between the first, second thermoelectric materials 27, 28 and the electrode plates 30, 31 is set to become a heating portion 34. The first, second thermoelectric materials 27, 28 are extended through the vacuum bulkhead 23, are secured with an epoxide series bonding agent and also, are retained in air tight condition, so that the cooling portion 33 and the heating portion 34 are respectively disposed within the chamber 21 and in the air. A DC power supply 35 is inserted halfway of the Cu line 32 taken out from the electrode plates 30, 31 constituting the heating portion 34. A cooling block 36 for cooling these heating portions 34, 34 is provided across between the heating portions 34, 34. Namely, one side of the stay 37 is mounted on one side of the cooling block 36, the other side of the stay 37 is mounted on the vacuum bulkhead 23 from the bolt 38. The cooling block 36 is supported with respect to the vacuum bulkhead 23 and is retained in contact condition with the heating portions 34, 34. The cooling block 36 has therein a cooling chamber 39, with which the respective one end of the circulating pipes 40, 41 of the cooling medium are communicated, with the other ends of the respective circulating pipes 40, 41 being communicated with a pump (not shown). An air cooling fin 42 is mounted on the outer face of the cooling block 36. And the cooling portion 33 is connected with the heating source (not shown).

In the above-described construction, the operation thereof will be described hereinafter.

When a current is fed into a circuit using the first, second thermoelectric materials 27, 28 by the DC current supply 35, the cooling portion 33 is cooled by the Peltier effect, and the heating portion 34 is heated. And the heating source may be electronically cooled by the cooling of the cooling portion 33. At this time, as there is no convention currents in the vacuum, the cooling efficiency of the heating source may be improved by the cooling portion 33. On one hand, the cooling water is circulated into the circulating pipe 40, the cooling room 39 of the cooling block 36, the circulating pipe 41 by the driving operation of the pump so as to cool the heating portion together with air cooling fin 42 by the cooling block 36, so that the transferring of the heat of the heating portion 34 into the cooling operation 33 by the first, second thermoelectric materials 27, 28 may be reduced so as to improve the cooling efficiency all the more. Also, the electronic cooling operation is effected as described hereinabove, the response speed of the cooling operation may be improved as compared with the conventional water cooling system or the like. Also, the first, second thermoelectric materials 27, 28 are made linear as described hereinabove, also, the first, second linear thermoelectric materials 27, 28 are covered with all the sheaths. The cooling portion 33 may be easily connected with the heating source by the use of the flexibility thereof.

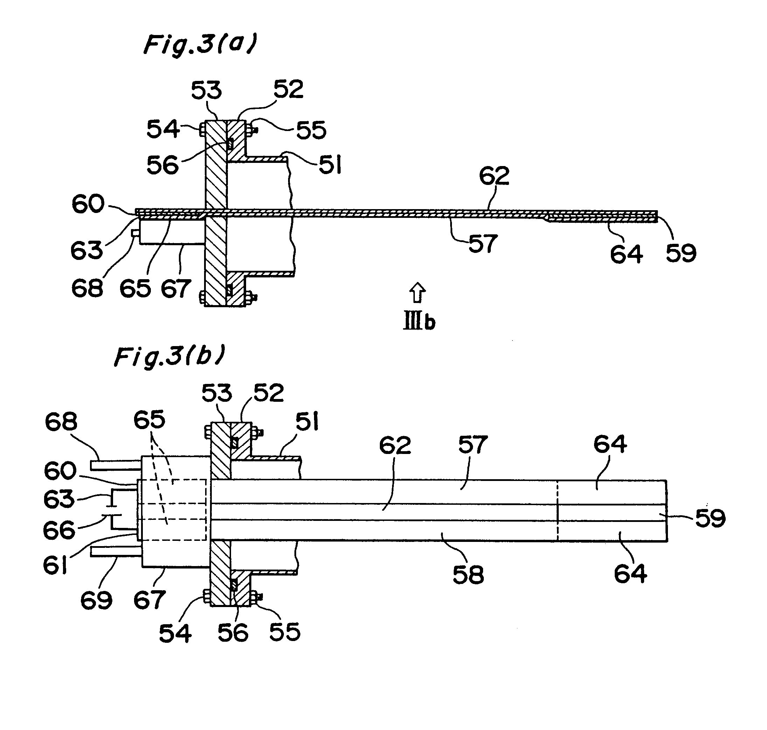

The present invention will be described hereinafter. Fig. 3 (a), (b) show the cooling apparatus in an embodiment of the present invention, with the (a) thereof being the sectional view of the essential portions, the (b) thereof being the IIIb arrow view of the (a) thereof.

As shown in Fig. 3 (a), (b), the vacuum bulkhead 53 is mounted with bolts 54 and nuts 55 on the flange 52 of the chamber 51 which becomes vacuum, and an 0 ring 56 is interposed in a compression condition between the flange 52 and the vacuum bulkhead 53, with the position between them being sealed. The first, second thermoelectric materials 57, 58 are in thin membrane shape together with the electrodes 59, 60, 61 on the thin basic plate 62 by, for example, $Bi_2Te_3$ + $Sb_2Te_3$, $Bi_2Te_3$ + $Bi_2Se_3$. Namely, the electrode 59 is provided by the vacuum evaporation or the like on one side end portion on the basic plate 62 made of the epoxide resin, glass or the like, a pair of electrodes 60, 61 are respectively provided along the long side on the other side end portion by the vacuum evaporation or the like. The first, second thermoelectric materials 57, 58 are provided by the vacuum evaporation or the like along the long side of the basic plate 62 on the basic plate 62 and the electrodes 59, 60, 61. Preferably the basic plate 61 is made of a deformable material, with the first, second thermoelectric materials 57, 58, the basic plate 62 or the like are composed to be freely deformable. The Cu line 63 is taken out from the electrodes 60, 61 to form a circuit. And the splicing portion between the first, second thermoelectric materials 57, 58 and the electrode 59 becomes a cooling portion 64, with the splicing portions between the first, second thermoelectric materials 57, 58 and the electrode plates 60, 61 are set to become the heating portion 65. The first, second thermoelectric material 57, 58 are extended through the vacuum bulkhead 53 and are secured with the epoxide series bonding agent, and also, are retained in the airtight condition, so that the cooling portion 64 and the heating portion 65 are respectively disposed within the chamber 51 and in the air. A DC power supply 66 is inserted halfway of the Cu line 63 which is taken out from the electrode plates 60, 61 constituting the heating portion 65. The cooling block 67 for cooling the heating portions 65, 65 is provided across the heating portions 65, 65. The cooling block 67 has a cooling room therein as in the second embodiment, with the respective one-ends of the circulating pipes 68, 69 being communicated with the cooling chamber, the other ends of the respective circulating pipes 68, 69 being communicated with the pump (not shown). And the cooling portion 64 is connected with the heating source (not shown).

In the above-described construction, the operation thereof will be described hereinafter.

When the current is fed into the circuit using the first, second thermoelectric materials 57, 58 by the DC power supply 66, the cooling portion 64 is cooled by the Peltier effect, the heating portion 65 is heated, the heating source may be electronically cooled by the cooling operation of the cooling portion 64. At this time, as there are no convection currents in the vacuum, the cooling efficiency of the heating source by the cooling portion 64 may be improved. On the other hand, the cooling operation may be circulated into the circulating pipe 68, the cooling room of the cooling block 67, the circulating pipe 69 by the driving operation of the pump so as to cool the heating portion 65 by the cooling block 67, so that the transferring of the heat of the heating portion 65 into the cooling portion 64 by the first, second thermoelectric materials 57, 58 may be controlled, thus improving the cooling efficiency all the more. Also, as the cooling operation is electronically effected as described hereinabove, the response speed of the cooling operation may be improved as compared with the conventional water cooling system or the like. Also, as described hereinabove, the first, second thermoelectric materials 57, 58 are provided in a thin membrane shape on the basic plate 62 The cooling portion 64 may be easily connected with the heating source by the use of the flexibility of the basic plate.

It is to be noted that even in the present embodiment, the cooling block 67 combined together with the air cooling fin may be used as in the second embodiment.

In the embodiments, for example, liquid nitrogen, instead of the cooling water, may- be circulated into the circulating pipes 40, 41, 68, 69, 87, 88 and the cooling blocks 36, 67, 86. By the use of the liquid nitrogen, the cooling operation may be effected to the same temperature as that when the heating source is cooled with the use of liquid helium.

As described hereinabove, according to the present invention, as the heating source is adapted to be electronically cooled by the cooling portion with the Peltier effect disposed in the vacuum by the feeding of the current from the DC power supply into a circuit formed by the use of the thermoelectric materials, the response speed of the cooling may be improved, also the construction is simplified, the cost may be lowered. Also, as there is no possibility of water leakage or the like as shown before, the pollution within the vacuum portion may be prevented.

Also, as there are convection currents in the vacuum, the cooling efficiency of the heating source is improved by the cooling portion. The heating portion of the circuit is cooled by the cooling means, so that the transferring operation of the heat of the heating portion to the cooling portion by the thermoelectric material may be reduced, with the cooling efficiency being improved all the more,

## Claims

1.  A cooling apparatus comprising:
    a first element formed of a first thermoelectric material (57), extending through a chamber wall (53), enclosing a chamber (51), from a position within that chamber to a position outside of said chamber;
    a second element formed of a second thermoelectric material (58) different than said first thermoelectric material, and extending through said chamber wall from a position within said chamber to a position outside of said chamber;
    a first electrode (59);
    a first splicing portion between said first and second thermoelectric materials and said first electrode (59) becoming a cooling portion (64);
    second electrodes (60, 61);
    second splicing portions between said first and second thermoelectric materials and said second electrodes, respectively, becoming a heating portion (65);
    the cooling portion and the heating portion being disposed on opposite sides of the chamber wall; and a DC power supply means electrically inserted between the second electrodes so as to form an electric circuit,
    characterized in that the apparatus further comprises a basic plate (62), said first and second elements being formed as thin membranes of thermoelectric materials on said basic plate extending through the chamber wall.

2.  A cooling apparatus in accordance with claim 1, wherein the thermoelectric material is linear.

3.  A cooling apparatus in accordance with claim 2, wherein the linear thermoelectric material is covered with a metallic sheath.

4.  A cooling apparatus as claimed in claim 1, characterized in that the thermoelectric material is a semiconductor comprising
    $$Bi_2Te_3 + Sb_2Te_3 \text{ or } Bi_2Te_3 + Bi_2Se_3.$$

5.  A cooling apparatus in accordance with either of claim 1 through claim 4, wherein a cooling means is provided on the heating portion (65).

6.  A cooling apparatus in accordance with claim 5, wherein the cooling means has a cooling block (67) having a cooling room, and a circulating pipe (68, 69) of a cooling medium communicated with the cooling room of the cooling block (67).

7.  A cooling apparatus in accordance with claim 5, wherein the cooling means is an air cooling fin (42).

8.  A cooling apparatus in accordance with claim 5, wherein the cooling means has a cooling block (67) having a cooling room, a circulating pipe of a cooling medium communicated with the cooling room of the cooling block, an air cooling fin mounted on the cooling block (67).

9.  A cooling apparatus in accordance with any of the preceeding claims, wherein the basic plate (62) is made of a deformable material.

## Patentansprüche

1.  Kühlvorrichtung
    mit einem ersten Element, das aus einem ersten thermoelektrischen Material (57) besteht und sich von einer Position innerhalb einer Kammer (51) durch eine Kammerwand (53) nach außerhalb der Kammer erstreckt;
    mit einem zweiten Element, das aus einem vom ersten thermoelektrischen Material abweichenden, zweiten Material besteht und sich von einer Position innerhalb der Kammer durch die Kammerwand nach außerhalb der Kammer erstreckt;
    mit einer ersten Elektrode (59);
    mit einem ersten Verbindungsabschnitt zwischen den ersten und zweiten thermoelektrischen Materialien und der ersten Elektrode (59) zur Bildung eines Kühlabschnittes (64);
    mit zweiten Verbindungsabschnitten zwischen dem ersten bzw. dem zweiten thermoelektrischen Materialien und zweiten Elektroden zur Bildung eines Heizabschnittes (65);
    wobei der Kühlabschnitt und der Heizabschnitt sich aufeinander entgegengesetzten Seiten der Kammerwand befinden; und
    mit einer Gleichstromversorgung, die zur Bildung eines elektrischen Stromkreises elektrisch zwischen die zweiten Elektroden geschaltet ist; gekennzeichnet durch
    eine Grundplatte (62), auf der die ersten und zweiten Elemente als dünne Membranen aus thermoelektrischem Material gebildet sind und sich durch die Kammerwand erstrecken.

2.  Kühlvorrichtung nach Anspruch 1, dadurch gekennzeichnet, daß das thermoelektrische Material linear ausgebildet ist.

3.  Kühlvorrichtung nach Anspruch 2, dadurch gekennzeichnet, daß das lineare thermoelektrische Material mit einer metallischen Schicht abgedeckt ist.

4.  Kühlvorrichtung nach Anspruch 1, dadurch gekennzeichnet, daß das thermoelektrische Material ein Halbleiter ist, der $Bi_2Te_3$ + $Sb_2Te_3$ oder $Bi_2Te_3$ + $Bi_2Se_3$ enthält.

5.  Kühlvorrichtung nach einem der Ansprüche 1 bis 4, dadurch gekennzeichnet, daß der Heizabschnitt (65) mit einer Kühlvorrichtung versehen ist.

6.  Kühlvorrichtung nach Anspruch 5, dadurch gekennzeichnet, daß die Kühlvorrichtung einen Kühlblock (67) mit einem Kühlraum sowie ein Zirkulationsrohr (68, 69) mit einem Kühlmedium aufweist, das mit dem Kühlraum des Kühlblockes (67) kommuniziert.

7.  Kühlvorrichtung nach Anspruch 5, dadurch gekennzeichnet, daß die Kühlvorrichtung ein Luftkühlkörper (42) ist.

8.  Kühlvorrichtung nach Anspruch 5, dadurch gekennzeichnet, daß die Kühlvorrichtung einen Kühlblock (67) mit einem Kühlraum sowie ein Zirkulationsrohr (68, 69) mit einem Kühlmedium aufweist, das mit dem Kühlraum des Kühlblockes (67) kommuniziert, und daß auf dem Kühlblock (67) ein Luftkühlkörper montiert ist.

9.  Kühlvorrichtung nach einem der vorstehenden Ansprüche, dadurch gekennzeichnet, daß die Grundplatte (62) aus einem deformierbaren Material besteht.

**Revendications**

1.  Appareil réfrigérant comprenant : un premier élément constitué par un premier matériau thermoélectrique (57), qui s'étend à travers une paroi de chambre (53) qui entoure une chambre (51), depuis une position à l'intérieur de cette chambre jusque dans une position à l'extérieur de ladite chambre, un second élément constitué par un second matériau thermoélectrique (58) différent dudit premier matériau thermoélectrique, et qui s'étend à travers ladite paroi de chambre depuis une position à l'intérieur de ladite chambre jusque dans une position à l'extérieur de ladite chambre, une première électrode (59), une première partie de jonction, entre lesdits premier et second matériaux thermoélectriques et ladite première électrode (59), qui devient une partie réfrigérante (64), des secondes électrodes (60, 61), des secondes parties de jonction, entre lesdits premier et second matériaux thermoélectriques et lesdites secondes électrodes, respectivement, qui deviennent une partie chauffante (65), la partie réfrigérante et la partie chauffante étant disposées sur des côtés opposés de la paroi de chambre, et un dispositif d'alimentation en courant continu inséré électriquement entre les secondes électrodes de manière à former un circuit électrique, caractérisé en ce que l'appareil comprend en outre une plaque de base (62), lesdits premier et second éléments étant sous forme de membranes minces de matériaux thermoélectriques sur ladite plaque de base qui s'étend à travers la paroi de chambre.

2.  Appareil réfrigérant selon la revendication 1, dans lequel le matériau thermoélectrique est linéaire.

3.  Appareil réfrigérant selon la revendication 2, dans lequel le matériau thermoélectrique linéaire est recouvert d'une gaine métallique.

4.  Appareil réfrigérant selon la revendication 1, caractérisé en ce que le matériau thermoélectrique est un semiconducteur comprenant $Bi_2Te_3$ + $Sb_2Te_3$ ou $Bi_2Te_3$ + $Bi_2Se_3$.

5.  Appareil réfrigérant selon l'une quelconque des revendications 1 à 4, dans lequel un dispositif réfrigérant est prévu sur la partie chauffante (65).

6.  Appareil réfrigérant selon la revendication 5, dans lequel le dispositif réfrigérant comporte un bloc réfrigérant (67) présentant une enceinte réfrigérante et une conduite de circulation (68, 69) pour un agent réfrigérant qui communique avec l'enceinte réfrigérante du bloc réfrigérant (67).

7.  Appareil réfrigérant selon la revendication 5, dans lequel le dispositif réfrigérant est une ailette de refroidissement par l'air (42).

8.  Appareil réfrigérant selon la revendication 5, dans lequel le dispositif réfrigérant comporte un bloc réfrigérant (67) qui présente une enceinte réfrigérante, une conduite de circulation pour un agent réfrigérant qui communique avec l'enceinte réfrigérante du bloc réfrigérant et une ailette de refroidissement par l'air montée sur le bloc réfrigérant (67).

9. Appareil réfrigérant selon l'une quelconque des revendications précédentes dans lequel la plaque de base (62) est constituée par un matériau déformable.

# Fig.1

Fig.2(a)

Fig.2(b)

Fig.2(c)

Fig.3(a)

Fig.3(b)